(19) **Europäisches Patentamt / European Patent Office / Office européen des brevets**

(11) **EP 4 418 335 A1**

(12) **EUROPEAN PATENT APPLICATION**
published in accordance with Art. 153(4) EPC

(43) Date of publication:
21.08.2024 Bulletin 2024/34

(21) Application number: 22880946.3

(22) Date of filing: 07.10.2022

(51) International Patent Classification (IPC):
$H01L\ 33/50^{(2010.01)}$    $C09K\ 11/08^{(2006.01)}$
$C09K\ 11/59^{(2006.01)}$    $C09K\ 11/61^{(2006.01)}$
$C09K\ 11/62^{(2006.01)}$    $C09K\ 11/64^{(2006.01)}$
$C09K\ 11/78^{(2006.01)}$    $C09K\ 11/79^{(2006.01)}$
$C09K\ 11/80^{(2006.01)}$    $C09K\ 11/86^{(2006.01)}$
$F21S\ 2/00^{(2016.01)}$    $F21S\ 43/14^{(2018.01)}$
$F21V\ 9/30^{(2018.01)}$    $F21V\ 9/38^{(2018.01)}$
$G02B\ 5/20^{(2006.01)}$    $F21Y\ 115/10^{(2016.01)}$

(52) Cooperative Patent Classification (CPC):
C09K 11/08; C09K 11/59; C09K 11/61;
C09K 11/62; C09K 11/64; C09K 11/77; F21S 2/00;
F21S 43/14; F21V 9/30; F21V 9/38; G02B 5/20;
H01L 33/50; F21Y 2115/10; Y02B 20/00

(86) International application number:
PCT/JP2022/037589

(87) International publication number:
WO 2023/063251 (20.04.2023 Gazette 2023/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 11.10.2021 JP 2021166903
11.10.2021 JP 2021166904

(71) Applicants:
• Mitsubishi Chemical Corporation
Chiyoda-ku
Tokyo 100-8251 (JP)

• National Institute for Materials Science
Tsukuba-shi, Ibaraki 305-0047 (JP)

(72) Inventors:
• UEDA, Kyota
Tokyo 100-8251 (JP)
• INATA, Yuhei
Tokyo 100-8251 (JP)
• HIROSAKI, Naoto
Tsukuba-shi, Ibaraki 305-0047 (JP)

(74) Representative: Hoffmann Eitle
Patent- und Rechtsanwälte PartmbB
Arabellastraße 30
81925 München (DE)

(54) **PHOSPHOR, LIGHT EMITTING DEVICE, LIGHTING DEVICE, IMAGE DISPLAY DEVICE AND INDICATOR LAMP FOR VEHICLES**

(57) A phosphor which comprises a crystal phase that has a composition represented by the following formula [1]; and a light emitting device which is provided with this phosphor.

$$Re_x(Sr_{1-y}MA_y)_aMB_bMC_cN_dO_eX_f \qquad [1]$$

(MA includes one or more elements selected from the group consisting of Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, f, x, and y respectively satisfy the following expressions.

**(Cont. next page)**

EP 4 418 335 A1

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

# Fig. 1

**Description**

Technical Field

The present invention relates to a phosphor, a light emitting device, a lighting device, an image display device, and an indicator lamp for a vehicle.

Background Art

In recent years, with the trend of energy conservation, there is an increasing demand for lightings and backlights formed of LEDs. The LED used here is a white light emitting LED having phosphors arranged on an LED chip that emits light having a blue wavelength or a near ultraviolet wavelength.

An LED formed of a nitride phosphor emitting red light and a phosphor emitting green light, which are arranged on a blue LED chip, using blue light from the blue LED chip as excitation light has been used in recent years as the above-described type of white light emitting LED. An LED is required to have higher luminous efficiency, and a light emitting device including a phosphor with excellent emission characteristics as a red phosphor is desired.

For example, a KSF phosphor represented by General Formula $K_2(Si,Ti)F_6$:Mn or General Formula $K_2Si_{1-x}Na_xAl_xF_6$:Mn $(0 < x < 1)$, and a CASN phosphor and a SCASN phosphor represented by General Formula $(Sr,Ca)AlSiN_3$:Eu are known as red phosphors used in a light emitting device. However, since the KSF phosphor is a deleterious substance of Mn activation, there is a demand for phosphors that are more suitable for a human body and the environment. Further, phosphors having a relatively large full width half maximum (FWHM) of about 80 nm to 90 nm have been used as the CASN phosphor and the SCASN phosphor, and thus new red phosphors having a smaller full width half maximum have been required.

Further, for example, PTL 1 describes a phosphor represented by Compositional Formula $SrLiAl_3N_4$:Eu, as a red phosphor that can be applied to a light emitting device in recent years, and a light emitting device formed of this phosphor in the example.

Citation List

Patent Literature

PTL 1: Japanese Patent No. 6335884

Summary of Invention

Technical Problem

However, since the phosphor described in PTL 1 has a long emission peak wavelength of about 650 nm, problems of low visual sensitivity for a red color, a decrease in the lumen equivalent (Lm/W) in a light emitting device, and degradation of the color rendering property or the color reproducibility when the phosphor is used in a lighting or a display occur.

In consideration of the above-described problems, an object of the present invention is to provide a new red phosphor emitting light of an emission color with a satisfactory rendering property and satisfactory color reproducibility, and a light emitting device, a lighting device, an image display device, and an indicator lamp for a vehicle, which includes the phosphor.

Solution to Problem

As a result of intensive examination conducted by the present inventors, it has been found that the above-described problems can be solved by using a phosphor that contains a crystal phase having a specific composition or a light emitting device including the phosphor, thereby completing the present invention.

That is, the present invention includes the following.

[1] A light emitting device comprising:

a phosphor that contains a crystal phase having a composition represented by the following formula [1],

$$Re_x(Sr_{1-y}MA_y)_aMB_bMC_cN_dO_eX_f \qquad [1]$$

EP 4 418 335 A1

(In the formula [1],
MA includes one or more elements selected from the group consisting of Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, f, x, and y respectively satisfy the following expressions.

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

[2] The light emitting device according to [1],
wherein in a powder X-ray diffraction spectrum of the phosphor, $0 < Ix/Iy < 0.2$ is satisfied when a peak intensity of (110) appearing in a region of $2\Theta = 10$ to 12 degrees is defined as Ix, and a peak intensity of (121) appearing in a region of $2\Theta = 37$ to 39 degrees is defined as Iy, and $Iz/Iy < 0.25$ is satisfied when a peak intensity of (111) derived from a SrO phase of an impurity phase appearing in a region of $2\Theta = 30$ degrees is defined as Iz.
[3] The light emitting device according to [1] or [2], wherein in the formula [1], $0.0 \leq y \leq 0.05$ is satisfied.
[4] The light emitting device according to any one of [1] to [3],
wherein in the formula [1], MA is Ca.
[5] The light emitting device according to any one of claims 1 to 4,
wherein in the formula [1], 80% by mole or greater of MB is formed of Li.
[6] The light emitting device according to any one of [1] to [5],
wherein in the formula [1], 80% by mole or greater of MC is formed of Al.
[7] The light emitting device according to any one of [1] to [6],
wherein in the formula [1], 80% by mole or greater of Re is formed of Eu.
[8] The light emitting device according to any one of [1] to [7],
wherein the light emitting device has an emission peak wavelength in a wavelength range of 620 nm or greater and 645 nm or less in an emission spectrum.
[9] The light emitting device according to any one of [1] to [8],
wherein a full width half maximum (FWHM) in an emission spectrum is 70 nm or less.
[10] The light emitting device according to any one of [1] to [9], further comprising:
a yellow phosphor and/or a green phosphor.
[11] The light emitting device according to [10], wherein the yellow phosphor and/or the green phosphor includes any one or more of a garnet-based phosphor, a silicate-based phosphor, a nitride phosphor, and an oxynitride phosphor.
[12] The light emitting device according to any one of [1] to [11], comprising:

a first phosphor; and
a second phosphor that emits visible light by irradiation with light from the first phosphor,
wherein the light emitting device includes a phosphor containing a crystal phase having a composition represented by the formula [1] as the second phosphor.

[13] A lighting device comprising:
the light emitting device according to [12] as a light source.
[14] An image display device comprising:
the light emitting device according to [12] as a light source.
[15] An indicator lamp for a vehicle, comprising:
the light emitting device according to [12] as a light source.
[16] A phosphor comprising:

a crystal phase having a composition represented by the following formula [1],

$$Re_x(Sr_{1-y}MA_y)_a MB_b MC_c N_d O_e X_f \qquad [1]$$

(In the formula [1],
MA includes one or more elements selected from the group consisting of Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, f, x, and y respectively satisfy the following expressions.

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

[17] The phosphor according to [16],
wherein in a powder X-ray diffraction spectrum of the phosphor, $0 < Ix/Iy < 0.2$ is satisfied when a peak intensity of (110) appearing in a region of $2\Theta = 10$ to 12 degrees is defined as Ix, and a peak intensity of (121) appearing in a region of $2\Theta = 37$ to 39 degrees is defined as Iy, and $Iz/Iy < 0.25$ is satisfied when a peak intensity of (111) derived from a SrO phase of an impurity phase appearing in a region of $2\Theta = 30$ degrees is defined as Iz.
[18] The phosphor according to [16] or [17],
wherein in the formula [1], $0.0 \leq y \leq 0.05$ is satisfied.
[19] The phosphor according to any one of [16] to [18], wherein in the formula [1], MA is Ca.
[20] The phosphor according to any one of [16] to [19], wherein in the formula [1], 80% by mole or greater of MB is formed of Li.

[21] The phosphor according to any one of [16] to [20], wherein in the formula [1], 80% by mole or greater of MC is formed of Al.

[22] The phosphor according to any one of [16] to [21], wherein in the formula [1], 80% by mole or greater of Re is formed of Eu.

[23] The phosphor according to any one of [16] to [22], wherein the phosphor has an emission peak wavelength in a wavelength range of 620 nm or greater and 645 nm or less in an emission spectrum.

[24] The phosphor according to any one of [16] to [23], wherein a full width half maximum (FWHM) in an emission spectrum is 70 nm or less.

Advantageous Effects of Invention

According to the present invention, it is possible to provide a new red phosphor emitting light of a satisfactory emission color, a light emitting device having a satisfactory color rendering property, a high-quality lighting device, a high-quality image display device, and a high-quality indicating lamp for a vehicle.

Brief Description of Drawings

[Fig. 1] Fig. 1 is an XRD spectrum chart of a phosphor in Example 2.
[Fig. 2] Fig. 2 is an emission spectrum chart of the phosphor in Example 2.
[Fig. 3] Fig. 3 is a chart showing emission characteristics of a simulated light emitting device in examples.

Description of Embodiments

Hereinafter, the present invention will be described with reference to embodiments and examples, but the present invention is not limited to such embodiments and such examples, and can be implemented by being optionally modified within a range not departing from the gist of the present invention.

Further, a numerical range shown using "to" in the present specification denotes a range including the numerical values before and after "to" as the lower limit and the upper limit. Further, in the compositional formula of a phosphor in the present specification, each compositional formula is shown by being punctuated with a comma. Further, when a plurality of elements are listed by punctuating a compositional formula with a comma (,), this indicates that the phosphor may contain one or two or more kinds of the listed elements in any combination or any composition. For example, Compositional Formula "$(Ca,Sr,Ba)Al_2O_4:Eu$" comprehensively shows all of Formulae "$CaAl_2O_4:Eu$", "$SrAl_2O_4:Eu$", "$BaAl_2O_4:Eu$", "$Ca_{1-x}Sr_xAl_2O_4:Eu$", "$Sr_{1-x}Ba_xAl_2O_4:Eu$", "$Ca_{1-xB}a_xAl_2O_4:Eu$", and "$Ca_{1-x-y}Sr_xBa_yAl_2O_4:Eu$" (here, in the formulae, $0 < x < 1$, $o < y < 1$, and $0 < x + y < 1$) .

According to an embodiment of the present invention, there is provided a phosphor that contains a crystal phase having a composition represented by the following formula [1] .

Further, according to another embodiment of the present invention, there is provided a light emitting device that includes the phosphor.

$$Re_x(Sr_{1-y}MA_y)_aMB_bMC_cN_dO_eX_f \qquad [1]$$

(In the formula [1],
MA includes one or more elements selected from the group consisting of Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, f, x, and y respectively satisfy the following expressions.

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

In the formula [1], europium (Eu), cerium (Ce), praseodymium (Pr), neodymium (Nd), samarium (Sm), terbium (Tb), dysprosium (Dy), holmium (Ho), erbium (Er), thulium (Tm), ytterbium (Yb), or the like can be used as Re, and in the present invention, from the viewpoints of the wave height and the wavelength and the emission quantum efficiency, Re includes one or more elements selected from the group consisting of Eu, Ce, Pr, Tb, and Dy, it is preferable that Re include Eu, more preferable that 80% by mole or greater of Re be formed of Eu, and still more preferable that Re be Eu.

In the formula [1], Sr represents strontium.

In the formula [1], MA includes one or more elements selected from the group consisting of calcium (Ca), barium (Ba), sodium (Na), potassium (K), yttrium (Y), gadolinium (Gd), and lanthanum (La), and it is preferable that MA include Ca and more preferable that MA be Ca.

In the formula [1], MB includes one or more elements selected from the group consisting of lithium (Li), magnesium (Mg), and zinc (Zn), and it is preferable that MB include Li, more preferable that 80% by mole or greater of MB be formed of Li, and still more preferable that MB be Li.

In the formula [1], MC includes one or more elements selected from the group consisting of aluminum (Al), silicon (Si), gallium (Ga), indium (In), and scandium (Sc), and it is preferable that MC include Al or Si, more preferable that MC include Al, still more preferable that 80% by mole or greater of MC be formed of Al, and particularly preferable that MC be Al.

In the formula [1], N represents a nitrogen element, and O represents an oxygen element.

In the formula [1], X includes one or more elements selected from the group consisting of fluorine (F), chlorine (Cl), bromine (Br), and iodine (I). That is, in a specific embodiment, from the viewpoints of stabilizing the crystal structure and achieving the charge balance of the entire phosphor, a part of N and O may be substituted with the halogen atom represented by X.

The formula [1] also shows a case of including a trace amount of components other than the specified components unavoidably or unintentionally or by being derived from a trace amount of additive components and the like.

Examples of the components other than the specified components include elements having one element number different from the element number of the intentionally added elements, homologous elements of the intentionally added elements, rare earth elements different from the intentionally added rare earth elements, halogen elements in a case of using a halide as a Re raw material, and other elements that can be typically contained in various raw materials as impurities.

As the case of including components other than the specified components unavoidably or unintentionally, a case of including such components by being derived from impurities of raw materials and a case of including such components by being introduced in production processes such as a grinding step and a synthesis step are considered. Further, examples of the trace amount of additive components include a reaction assistant and a Re raw material.

In the formula [1], a, b, c, d, e, f, and x each denote the molar content of MA, MB, MC, N, O, X, and Re contained in the phosphor. Further, y represents the molar content of MA when the molar total amount of Sr and MA is set to 1.

The value of a is usually 0.7 or more, preferably 0.8 or more, more preferably 0.85 or more, and even more preferably 0.9 or more, and usually 1.3 or less, preferably 1.2 or more, and more preferably 1.1 or less.

The values of b and c are each independently usually 1.4 or more, preferably 1.6 or more, and more preferably 1.8 or more, and usually 2.6 or less, preferably 2.4 or less, and more preferably 2.2 or less.

The values of d and e are each independently usually 1.1 or more, preferably 1.4 or more, and more preferably 1.7 or more, and usually 2.9 or less, preferably 2.6 or less, and more preferably 2.3 or less.

The value of f is usually 0.0 or more, and usually 0.1 or less, preferably 0.06 or less, more preferably 0.04 or less, and still more preferably 0.02 or less.

The value of x is larger than 0.0, usually 0.0001 or more, and preferably 0.001 or more, and usually 0.2 or less, preferably 0.15 or less, more preferably 0.1 or less, and still more preferably 0.08 or less.

When b, c, d, and e are in the above-described ranges, the crystal structure is stabilized. Further, the values of d, e, and f can be appropriately adjusted for the purpose of achieving the charge balance of the entire phosphor.

The value of y is larger than 0.0, usually 0.01 or more, preferably 0.05 or more, more preferably 0.1 or more, and even more preferably 0.2 or more, and usually 0.7 or less, preferably 0.6 or less, more preferably 0.5 or less, and still more preferably 0.4 or less.

When the value of y is in the above-described ranges, the crystal structure is stabilized, and a phosphor with a satisfactory emission peak wavelength is obtained.

Further, when the value of a is in the above-described ranges, the crystal structure is stabilized, and a phosphor with less different phases is obtained.

The value of b + c and the value of d + e + f are each independently preferably 3.0 or greater, more preferably 3.4 or greater, and still more preferably 3.7 or greater, and preferably 5.0 or less, more preferably 4.6 or less, and still more preferably 4.3 or less.

When the value of b + c and the value of d + e + f are each in the above-described ranges, the crystal structure is stabilized.

It is preferable that all the contents be in the above-described ranges from the viewpoint that the emission peak wavelength of the phosphor to be obtained and the full width half maximum in the emission spectrum are satisfactory.

Further, a method of specifying the elemental composition of the phosphor is not particularly limited and can be determined by a known method, and examples of such a method include GD-MS, ICP spectroscopy, and an energy dispersive X-ray analyzer (EDX).

[Particle diameter of crystal phase]

The particle diameter of the crystal phase of the phosphor according to the present embodiment is typically 2 $\mu$m or greater and 35 $\mu$m or less in terms of the average particle diameter on a volume basis, the lower limit thereof is preferably 3 um, more preferably 4 $\mu$m, and still more preferably 5 um, and the upper limit thereof is preferably 30 $\mu$m or less, more preferably 25 um or less, still more preferably 20 um, and particularly preferably 15 um. It is preferable that the average particle diameter of the crystal phase on a volume basis be greater than or equal to the above-described lower limits from the viewpoint of the emission characteristics of the crystal phase exhibiting in an LED package and preferable that the average particle diameter thereof be less than or equal to the above-described upper limits from the viewpoint that the crystal phase can avoid noise obstruction in a process of producing an LED package.

The average particle diameter of the crystal phase of the phosphor on a volume basis can be measured by a laser particle size meter. Here, the average particle diameter on a volume basis is defined as the particle diameter ($d_{50}$) at which the relative particle amount on a volume basis reaches 50% when the particle size distribution (cumulative distribution) is determined by measuring a sample with a particle size distribution measuring device that uses a laser diffraction scattering method as a measurement principle.

[Physical properties and the like of phosphor]

[Space group]

It is more preferable that a crystal system (space group) in the phosphor according to the present embodiment be P42/m. The space group in the phosphor is not particularly limited as long as an average structure that has been statistically considered in a range where the structure can be distinguished by powder X-ray diffraction or single crystal X-ray diffraction shows a repeating period with the above-described length, but it is preferable that the space group belong to No. 84 based on "International Tables for Crystallography (Third, revised edition), Volume A SPACE-GROUP SYMMETRY".

In a case of the space group as described above, the full width half maximum (FWHM) in the emission spectrum decreases, and a phosphor with satisfactory luminous efficiency can be obtained.

Here, the space group can be determined by a known method, for example, electron beam diffraction or X-ray diffraction structure analysis and neutron beam diffraction structure analysis using powder or a single crystal.

In the powder X-ray diffraction spectrum of the phosphor according to the present embodiment, when a peak intensity of (110) appearing in a region of $2\Theta$ = 10 to 12 degrees is defined as Ix, a peak intensity of (121) appearing in a region of $2\Theta$ = 37 to 39 degrees is defined as Iy, and a peak intensity of (111) derived from a SrO phase of an impurity phase appearing in a region of $2\Theta$ = 30 degrees is defined as Iz, Ix/Iy which is a relative intensity of Ix in a case where

ly is set to 1 is typically 0.3 or less, preferably 0.25 or less, more preferably 0.2 or less, and still more preferably 0.15 or less, and is typically 0 or greater, but preferably as small as possible.

Further, Iz/Iy which is a relative intensity of Iz when Iy is set to 1 is typically 0.5 or less, preferably 0.4 or less, more preferably 0.3 or less, still more preferably 0.25 or less, particularly preferably 0.2 or less, and most preferably 0.15 or less, and is typically 0 or greater, but preferably as small as possible.

The peak of (121) described above is one of the characteristic peaks observed when the crystal phase (space group) is P42/m, and a phosphor in which the phase purity of P42/m is higher can be obtained when Iy is relatively high.

In a case where Ix/Iy or Iz/Iy is less than or equal to the above-described upper limits, since the phosphor has high phase purity and a small full width half maximum (FWHM), and thus the luminous efficiency of the light emitting device is improved.

[Characteristics of emission spectrum]

The phosphor according to the present embodiment is a red phosphor emitting light of a satisfactory emission color. That is, the phosphor is excited by irradiation with light having an appropriate wavelength and emits red light showing a satisfactory emission peak wavelength and a satisfactory full width half maximum (FWHM) in the emission spectrum. Hereinafter, the excitation wavelength, the emission peak wavelength, and the full width half maximum (FWHM) related to the above-described emission spectrum and the measurement of the emission spectrum will be described.

(Excitation wavelength)

The phosphor according to the present embodiment has excitation peaks in wavelength ranges of typically 270 nm or greater, preferably 300 nm or greater, more preferably 320 nm or greater, still more preferably 350 nm or greater, and particularly preferably 400 nm or greater and is typically 500 nm or less, preferably 480 nm or less, and more preferably 460 nm or less. That is, the phosphor is excited with light in a near ultraviolet to blue region.

Further, the description of the shape of the emission spectrum, the emission peak wavelength, and the full width half maximum can be applied regardless of the excitation wavelength, but it is preferable that the phosphor radiate light having a wavelength in the above-described ranges where absorption and excitation efficiency are satisfactory, from the viewpoint of improving the quantum efficiency.

(Emission peak wavelength)

The peak wavelength of the phosphor according to the present embodiment in the emission spectrum is typically 620 nm or greater, preferably 625 nm or greater, and more preferably 630 nm or greater. Further, the peak wavelength of the phosphor in this emission spectrum is typically 649 nm or less, preferably 645 nm or less, and more preferably 640 nm or less.

When the peak wavelength of the phosphor in the emission spectrum is in the above-described ranges, the emission color is a satisfactory red color, and a light emitting device with a satisfactory color rendering property and satisfactory color reproducibility can be obtained by using such a phosphor in a light emitting device. Further, when the peak wavelength of the phosphor in the emission spectrum is less than or equal to the above-described upper limits, a light emitting device having satisfactory visual sensitivity of a red color and a satisfactory lumen equivalent of 1 m/W can be provided.

(Full width half maximum of emission spectrum)

In the phosphor according to the present embodiment, the full width half maximum of the emission peak in the emission spectrum is typically 80 nm or less, preferably 70 nm or less, more preferably 60 nm or less, still more preferably 55 nm or less, particularly preferably 50 nm or less and is typically 10 nm or greater.

When the full width half maximum of the emission peak is in the above-described ranges, the color reproduction range of an image display device can be widened without reducing the color purity in a case where the phosphor is used in an image display device such as a liquid crystal display.

Further, when the emission peak wavelength and the full width half maximum are less than or equal to the above-described upper limits, a phosphor with relatively high visual sensitivity in the emission wavelength range can be provided, and a light emitting device with high conversion efficiency can be provided by using such a phosphor in a light emitting device.

In addition, for example, a GaN-based LED can be used to excite the phosphor according to the present embodiment with light having a wavelength of 450 nm. Further, the measurement of the emission spectrum of the phosphor and the calculation of the emission peak wavelength, the peak relative intensity, and the peak full width half maximum can be performed by using a light source having an emission wavelength of 300 to 400 nm, such as a commercially available xenon lamp, and a commercially available spectrum measuring device such as a fluorescence measuring device provided with a typical photodetector.

<Method of producing phosphor>

The phosphor according to the present embodiment can be synthesized by mixing the raw materials of each element constituting the phosphor such that the proportion of each element satisfies the formula [1] and heating the mixture.

The raw materials of each element (Sr, MA, MB, MC, and Re) are not particularly limited, and examples thereof include a single substance of each element, an oxide, a nitride, a hydroxide, a chloride, a halide such as a fluoride, an inorganic salt such as a sulfate, a nitrate, or a phosphate, and an organic acid salt such as an acetate. In addition, a compound containing two or more kinds of the element groups may be used. Further, each compound may be a hydrate.

In addition, $Sr_3N_2$, $Ca_3N_2$, $Li_3N$, $AlN$, $Al_2O_3$, and $EuF_3$ or $Eu_2O_3$ are used as starting materials in examples described below.

A method of obtaining each raw material is not particularly limited, and commercially available products can be purchased and used.

The purity of each raw material is not particularly limited, but from the viewpoints of accurately calculating the element ratio and avoiding appearance of different phases due to impurities, the purity is preferably as high as possible, typically 90% by mole or greater, preferably 95% by mole or greater, more preferably 97% by mole or greater, and still more preferably 99% by mole or greater. Further, the upper limit thereof is not particularly limited, but is typically 100% by mole or less, and impurities that are unavoidably mixed may be contained in the elements.

In the examples described below, all raw materials used have a purity of 95% by mole or greater.

An oxygen element (O), a nitrogen element (N), and a halogen element (X) can be supplied by using an oxide, a nitride, a halide, and the like as the raw materials of each element, and can be appropriately contained by preparing an oxygen- or nitrogen-containing atmosphere during the synthesis reaction.

[Mixing step]

A method of mixing the raw materials is not particularly limited, and a known method can be used. For example, phosphor raw materials are weighed to obtain the target composition and sufficiently mixed using a ball mill or the like, thereby obtaining a phosphor raw material mixture. The mixing method is not particularly limited, and specific examples thereof include the following methods (a) and (b).

(a) A dry mixing method of grinding and mixing the above-described phosphor raw materials by combining a dry grinder such as a hammer mill, a roll mill, a ball mill, or a jet mill or grinding carried out using a mortar or a pestle and a mixer such as a ribbon blender, a V-type blender, or a Henschel mixer or mixing carried out using a mortar or a pestle

(b) A wet mixing method of adding a solvent such as water or a dispersion medium to the above-described phosphor raw materials, mixing the mixture using a grinder, a mortar and a pestle, an evaporating dish and a stirring rod, or the like, allowing the mixture to be in a state of a solvent or a slurry, and drying the mixture by spray drying, heat drying, natural drying, or the like.

The phosphor raw materials may be mixed by any of the dry mixing method or the wet mixing method, but a dry mixing method or a wet mixing method using a water-insoluble solvent is preferable in order to avoid contamination of the phosphor raw materials due to the moisture.

Further, the method (a) is employed in the examples described below.

[Heating step]

In a heating step, for example, the phosphor raw material mixture obtained in the mixing step is put into a crucible and subsequently heated at a temperature of 700°C to 1,200°C and preferably at a temperature of 750°C to 1,000°C.

A material that does not react with the phosphor raw materials or the reactant is preferable as the material of the crucible, and examples thereof include ceramics such as alumina, quartz, boron nitride, silicon carbide, and silicon nitride, metals such as nickel, platinum, molybdenum, tungsten, tantalum, niobium, iridium, and rhodium, and alloys containing these as main components. In the examples described below, a crucible made of nickel is used.

It is preferable that the heating be performed in an inert atmosphere, and a gas containing nitrogen, argon, helium, or the like as a main component can be used.

In the heating step, the phosphor raw material mixture is heated in the above-described temperature ranges for typically 1 hour to 400 hours, preferably 5 hours to 150 hours, and more preferably 10 hours to 120 hours. Further, the present heating step may be performed once or a plurality of times, and examples of an aspect of performing the heating step a plurality of times include an aspect of performing annealing for heating the mixture under pressure in order to repair defects and an aspect of primarily heating the mixture to obtain primary particles or an intermediate and secondarily heating the mixture to obtain secondary particles or a final product.

In this manner, the phosphor according to the present embodiment can be obtained.

<Light emitting device>

According to another embodiment of the present invention, there is provided a light emitting device including a first phosphor (excitation light source) and a second phosphor that emits visible light by irradiation with light from the first phosphor, in which the light emitting device includes the phosphor according to the present embodiment that contains a crystal phase having a composition represented by the formula [1] as the second phosphor. Here, the second phosphor may be used alone or two or more kinds thereof may be used in any combination or at any ratios.

The light emitting device in the present embodiment includes the phosphor according to the present embodiment which contains a crystal phase having a composition represented by the formula [1] as the second phosphor and can further use a phosphor emitting fluorescence in a yellow, green, or red region (orange or red) when irradiated with light from an excitation light source. Specifically, in a case of constituting the light emitting device, a phosphor having an emission peak in a wavelength range of 550 nm or greater and 600 nm or less is preferable as a yellow phosphor, and a phosphor having an emission peak in a wavelength range of 500 nm or greater and 560 nm or less is preferable as a green phosphor. Further, an orange or red phosphor is a phosphor having an emission peak in a wavelength range of typically 615 nm or greater, preferably 620 nm or greater, more preferably 625 nm or greater, still more preferably 630 nm or greater, and typically 660 nm or less, preferably 650 nm or less, more preferably 645 nm or less, and still more preferably 640 nm or less.

A light emitting device with excellent color reproducibility can be provided by appropriately combining phosphors in the above-described wavelength ranges. Further, an excitation light source having an emission peak in a wavelength range of less than 420 nm may be used as the excitation light source.

Hereinafter, an aspect of the light emitting device that uses the phosphor according to the present embodiment, which has an emission peak in a wavelength range of 620 nm or greater and 645 nm or less and contains a crystal phase having a composition represented by the formula [1] as a red phosphor, and uses a phosphor having an emission peak in a wavelength range of 300 nm or greater and 460 nm or less as the first phosphor will be described, but the present embodiment is not limited thereto.

In the above-described case, the light emitting device according to the present embodiment can be formed, for example, according to the following aspect (a), (b), or (c).

(A) An aspect of using a phosphor having an emission peak in a wavelength range of 300 nm or greater and 460 nm or less as the first phosphor, at least one phosphor (yellow phosphor) having an emission peak in a wavelength range of 500 nm or greater and 600 nm or less as the second phosphor, and the phosphor according to the present embodiment which contains a crystal phase having a composition represented by the formula [1]
(B) An aspect of using a phosphor having an emission peak in a wavelength range of 300 nm or greater and 460 nm or less as the first phosphor, at least one phosphor (green phosphor) having an emission peak in a wavelength range of 500 nm or greater and 560 nm or less as the second phosphor, and the phosphor according to the present embodiment which contains a crystal phase having a composition represented by the formula [1]
(C) An aspect of using a phosphor having an emission peak in a wavelength range of 300 nm or greater and 460 nm or less as the first phosphor, at least one phosphor (yellow phosphor) having an emission peak in a wavelength range of 550 nm or greater and 600 nm or less as the second phosphor, at least one phosphor (green phosphor) having an emission peak in a wavelength range of 500 nm or greater and 560 nm or less, and the phosphor according to the present embodiment which contains a crystal phase having a composition represented by the formula [1]

Commercially available products can be used as the green phosphor or the yellow phosphor in the above-described aspects, and a garnet-based phosphor, a silicate-based phosphor, a nitride phosphor, an oxynitride phosphor, and the like can be used.

(Yellow Phosphor)

Examples of the garnet-based phosphor that can be used as the yellow phosphor include (Y, Gd, Lu, Tb,

La)$_3$(Al, Ga)$_5$O$_{12}$:(Ce, Eu, Nd), and the like. Examples of the silicate-based phosphor include (Ba, Sr, Ca, Mg)$_2$SiO$_4$:(Eu, Ce), and the like. Examples of the nitride phosphor and the oxynitride phosphor include (Ba, Ca, Mg) Si$_2$O$_2$N$_2$:Eu (SION-based phosphor), (Li, Ca)$_2$ (Si, Al)$_{12}$ (O, N)$_{16}$ : (Ce, Eu) ($\alpha$-sialon phosphor), (Ca, Sr) AlSi$_4$ (O, N)$_7$: (Ce, Eu) (1147 phosphor), (La, Ca, Y, Gd)$_3$ (Al , Si)$_6$N$_{11}$:(Ce, Eu) (LSN phosphor), and the like.

These may be used alone or in combination of two or more.

Among the above-mentioned phosphors, garnet-based phosphors are preferable as the yellow phosphor, and among them, YAG-based phosphor represented by Y$_3$Al$_5$O$_{12}$:Ce is most preferable.

(Green Phosphor)

Examples of the garnet-based phosphor that can be used as the green phosphor include (Y, Gd, Lu, Tb, La)$_3$(Al, Ga)$_5$O$_{12}$:(Ce, Eu, Nd), Ca$_3$(Sc, Mg) $_2$Si$_3$O$_{12}$: (Ce, Eu) (CSMS phosphor), and the like. Examples of the silicate-based phosphor include (Ba, Sr, Ca, Mg)$_3$SiO$_{10}$:(Eu,Ce), (Ba, Sr, Ca, Mg)$_2$SiO$_4$:(Ce, Eu) (BSS phosphor), and the like. Examples of the oxide phosphor include (Ca, Sr, Ba, Mg) (Sc, Zn)$_2$O$_4$:(Ce, Eu) (CASO phosphor), and the like. Examples of the nitride phosphor and the oxynitride phosphor include (Ba, Sr, Ca, Mg) Si$_2$O$_2$N$_2$: (Eu, Ce), Si$_{6-z}$Al$_z$O$_z$N$_{8-z}$: (Eu, Ce) ($\beta$-sialon phosphor) (0<z$\leqq$1), (Ba, Sr, Ca, Mg, La)$_3$(Si,Al)$_6$O$_{12}$N$_2$:(Eu,Ce) (BSON phosphor), and the like. Examples of the aluminate phosphor include (Ba, Sr, Ca, Mg)$_2$Al$_{10}$O$_{12}$:(Eu, Mn) (GBAM-based phosphor), and the like.

These may be used alone or in combination of two or more.

(Red phosphor)

As a red phosphor, the phosphor according to the present embodiment which contains a crystal phase having a composition represented by the formula [1] is used, and for example, other orange or red phosphors such as a Mn-activated fluoride phosphor, a garnet-based phosphor, a sulfide phosphor, a nanoparticle phosphor, a nitride phosphor, and an oxynitride phosphor can be used in addition to the phosphor according to the present embodiment. For example, the following phosphors can be used as the other orange or red phosphors.

Examples of the Mn-activated fluoride phosphor include K$_2$(Si,Ti)F$_6$:Mn, K$_2$Si$_{1-x}$Na$_x$Al$_x$F$_6$:Mn (0<x<1) (collectively KSF phosphors), and the like. Examples of the sulfide phosphor include (Sr,Ca)S:Eu (CAS phosphor), La$_2$O$_2$S:Eu (LOS phosphor), and the like. Examples of the garnet-based phosphor include (Y, Lu, Gd, Tb)$_3$Mg$_2$AlSi$_2$O$_{12}$:Ce, and the like. Examples of the nanoparticles include CdSe. Examples of the nitride or oxynitride phosphor include (Sr,Ca)AlSiN$_3$:Eu (S/CASN phosphor), (CaAlSiN$_3$)$_{1-x}$·(SiO$_2$N$_2$)$_x$:Eu (CASON phosphor), (La , Ca)$_3$(Al,Si)$_6$N$_{11}$:Eu (LSN phosphor), (Ca,Sr,Ba)$_2$Si$_5$(N,O)$_8$:Eu(258 phosphor), (Sr,Ca)Al$_{1+x}$Si$_{4-x}$O$_x$N$_{7-x}$ : Eu (1147 phosphor), Mx (Si, Al)$_{12}$ (O, N)$_{16}$: Eu (M is Ca, Sr, etc.) ($\alpha$ sialon phosphor), Li (Sr, Ba) Al$_3$N$_4$: Eu (the above x are all 0<x<1.), and the like.

These may be used alone or in combination of two or more.

[Configuration of light emitting device]

The light emitting device according to the present embodiment includes a first phosphor (excitation light source) and can use at least the phosphor according to the present embodiment which contains a crystal phase having a composition represented by the formula [1] as a second phosphor, and the configuration thereof is not limited, and a known device configuration can be optionally employed.

Examples of the device configuration and the embodiments of the light emitting device include those described in JP2007-291352A. Further, examples of the aspect of the light emitting device include a bullet type device, a cup type device, a chip-on-board device, and a remote phosphor device.

[Applications of light emitting device]

The applications of the light emitting device according to the present embodiment are not particularly limited, and the light emitting device can be used in various fields where typical light emitting devices have been used, but can be suitably used as a light source of a lighting device or an image display device in the various fields from the viewpoint of the color rendering property.

Further, from the viewpoint of including a red phosphor with a satisfactory emission wavelength, the light emitting device can be used in an indicator lamp for a vehicle which emits red light or an indicator lamp for a vehicle which emits white light including red light.

[Lighting device]

According to an embodiment of the present invention, there is provided a lighting device including the light emitting device as a light source.

When the light emitting device is applied to the lighting device, the specific configuration of the lighting device is not limited, and a light emitting device as described above may be appropriately incorporated into a known lighting device and then used. Examples of such a lighting device include a surface light emitting lighting device in which a plurality of light emitting devices are arranged on the bottom of a holding case.

[Image display device]

According to an embodiment of the present invention, there is provided an image display device including the light emitting device as a light source.

When the light emitting device is used as a light source of the image display device, the specific configuration of the image display device is not limited, but it is preferable that the image display device be used together with a color filter. For example, when a color image display device formed of a color liquid crystal display device is used as the image display device, an image display device can be formed by using the light emitting device as a backlight and combining an optical shutter formed of a liquid crystal with a color filter having red, green, and blue pixels.

[Indicator lamp for vehicle]

According to an embodiment of the present invention, there is provided an indicator lamp for a vehicle including the light emitting device.

According to a specific embodiment, a light emitting device radiating white light is preferable as the light emitting device used in the indicator lamp for a vehicle. In the light emitting device radiating white light, the light radiated from the light emitting device has a light color deviation duv of -0.0200 to 0.0200 from a blackbody radiation locus, and the color temperature is preferably 5,000 K or higher and 30,000 K or lower.

According to a specific embodiment, a light emitting device radiating red light is preferable as the light emitting device used in the indicator lamp for a vehicle. In the embodiment, for example, the light emitting device absorbs blue light radiated from a blue LED chip and emits red light, and thus an indicator lamp for a vehicle which emits red light may be obtained.

Examples of the indicator lamp for a vehicle include lightings provided in a vehicle for the purpose of performing a display for other vehicles, people, and the like, such as head lamps, side lamps, back lamps, turn signals, brake lamps, and fog lamps in vehicles.

EXAMPLES

Hereinafter, the present invention will be described in more details with reference to examples, but the present invention is not limited to the following examples unless the gist of the present invention is exceeded.

{Measuring method}

[Measurement of powder X-ray diffraction]

Powder X-ray diffraction (XRD) was precisely measured by a powder X-ray diffraction device SmartLab 3 (manufactured by Rigaku Corporation).

The measurement conditions are as follows.

Use of CuK$\alpha$ tube
X-ray output = 40 kV, 200 mA
Divergence slit: automatic
Detector: high-speed one-dimensional X-ray detector (D/teX Ultra 250)
Scanning range: 2$\Theta$ = 5 to 80 degrees
Reading width = 0.02 degrees

[Measurement of emission spectrum]

A xenon lamp was used to irradiate a phosphor with light having a wavelength of 365 nm, and the emission spectrum in a wavelength range of 450 to 800 nm was measured using a spectrophotofluorometer.

[Examples 1 to 5, Comparative Example 1, and Reference Example 1]

In Examples 1 to 5, red phosphors (samples 1 to 5) having compositions listed in Table 1 were produced by the method of producing the phosphor according to the present embodiment.

Further, in Comparative Example 1, a red phosphor of a sample 6 in which the formula [1] was not satisfied was produced by setting the content of Ca to 0.

The composition, the space group, the emission peak wavelength, and the full width half maximum of each phosphor are listed in Table 1. Further, the literature values of $SrLiAl_3N_4$ are also listed in Table 1 as Reference Example 1.

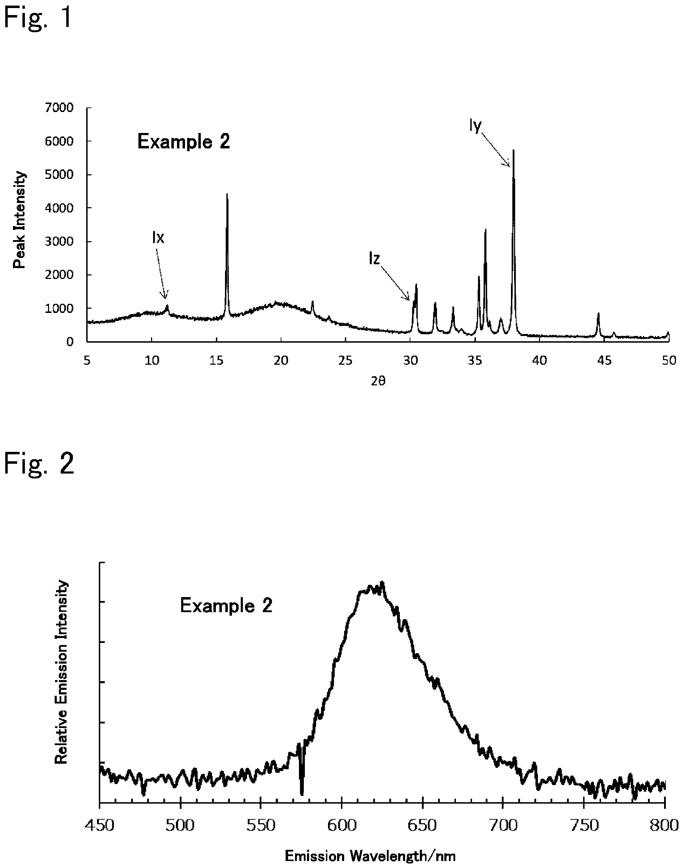

Further, the XRD spectrum chart and the emission spectrum chart of the phosphor of Example 2 are respectively shown in Figs. 1 and 2 as representative examples. The full width half maximum of the phosphor of Example 2 (sample 2) was 65 nm, which was satisfactory, and $Ix/Iy$ and $Iz/Iy$ in XRD were respectively 0.194 and 0.216, which indicates that the purity of the phase was satisfactory, and thus it was found that a light emitting device with satisfactory conversion efficiency was obtained when the phosphor was applied to the light emitting device.

[Table 1]

| | | Composition | Emission peak wavelength [nm] | Full width half maximum [nm] | Space group |
|---|---|---|---|---|---|
| | Example 1 | $Sr_{0.9}Ca_{0.1}Li_2Al_2N_2O_2:Eu_{0.01}$ | 623 | | P42/m |
| | Example 2 | $Sr_{0.8}Ca_{0.2}Li_2Al_2N_2O_2:Eu_{0.01}$ | 625 | 65 | P42/m |
| | Example 3 | $Sr_{0.7}Ca_{0.3}Li_2Al_2N_2O_2:Eu_{0.01}$ | 628 | | P42/m |
| | Example 4 | $Sr_{0.6}Ca_{0.4}Li_2Al_2N_2O_2:Eu_{0.01}$ | 630 | | P42/m |
| | Example 5 | $Sr_{0.5}Ca_{0.5}Li_2Al_2N_2O_2:Eu_{0.01}$ | 636 | | P42/m |
| | Comparative Example 1 | $SrLi_2Al_2N_2O_2:Eu$ | 617 | 60 | P42/m |
| | Reference Example 1 | $SrLiAl_3N_4:Eu$ | 650 | 48 | P-1 |

The phosphors of samples 1 to 5 according to the present examples all exhibited a space group of P42/m, and the emission peak wavelength was 620 nm or greater and 640 nm or less which was ideal for the color rendering property and the color reproducibility when the phosphor was used in a white LED.

Next, the results of the simulation related to the characteristics of the light emitting device including the phosphor satisfying the formula [1] according to the examples will be described.

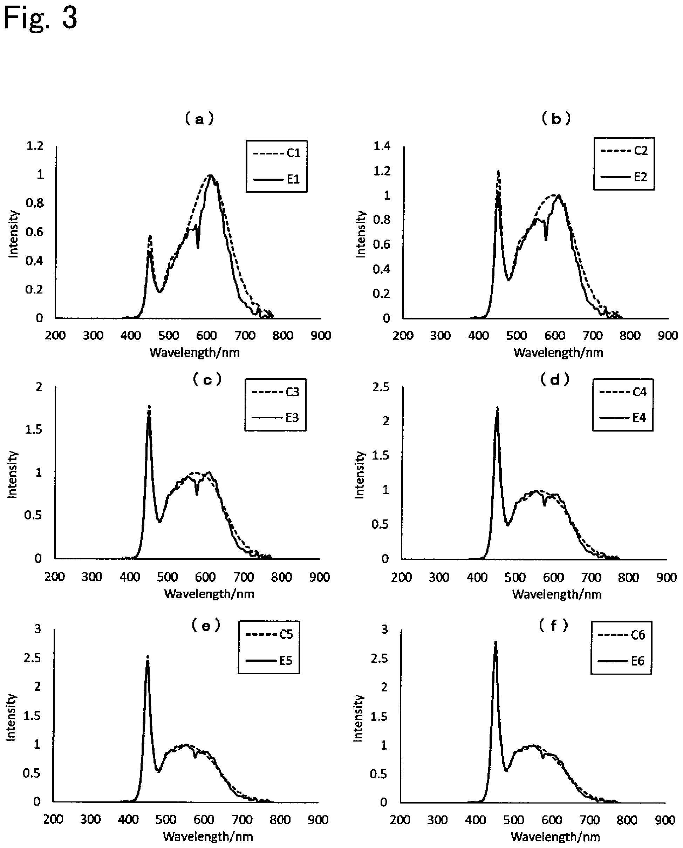

The emission spectrum of a white LED including the phosphor of Example 2 or a SCASN phosphor (BR-102C, manufactured by Mitsubishi Chemical Corporation) having an emission peak wavelength of 628 nm as a red phosphor and a LuAG phosphor (BG-801/A4, manufactured by Mitsubishi Chemical Corporation) as a green phosphor was derived by the above-described method. All simulations were performed by assuming a blue LED chip emitting light having an emission peak wavelength of 449 nm. Further, the amounts of the green phosphor and the red phosphor were adjusted such that the chromaticity coordinate matched with the coordinate of the white light having a color temperature of 3,000 K to 8,000 K on the Planck Curve, and the characteristics in each color temperature were compared. The results are shown in Figs. 3(a) to 3(f). Further, the results of determining a color rendering property evaluation number Ra, a color rendering property evaluation number R9 of the red color, and the conversion efficiency (LER) from each spectrum are listed in Table 2.

Further, "relative value of mass of phosphor" denotes the mass proportion of the phosphor of each color when the total mass of the red phosphor and the green phosphor was set to 100%.

[Table 2]

| No. | Red phosphor | Relative value of mass of phosphor | | Chromaticity coordinate value | | Color temperature /K | LER (Lm/ Wopt) | Color rendering property | |
|---|---|---|---|---|---|---|---|---|---|
| | | Red color | Green color | x | y | | | Ra | R9 |
| C1 | SCASN | 15.20% | 84.80% | 0.4368 | 0.4039 | 3000 | 316 | 84 | 20 |
| E1 | Sample 2 | 25.70% | 74.30% | | | | 330 | 90 | 33 |
| C2 | SCASN | 12.40% | 87.60% | 0.3804 | 0.3768 | 4000 | 315 | 86 | 28 |
| E2 | Sample 2 | 20.40% | 79.60% | | | | 324 | 91 | 42 |
| C3 | SCASN | 10.80% | 89.20% | 0.3451 | 0.3516 | 5000 | 307 | 86 | 31 |
| E3 | Sample 2 | 17.30% | 82.70% | | | | 314 | 90 | 45 |
| C4 | SCASN | 9.70% | 90.30% | 0.3221 | 0.3316 | 6000 | 299 | 87 | 35 |
| E4 | Sample 2 | 15.30% | 84.70% | | | | 304 | 90 | 48 |
| C5 | SCASN | 8.90% | 91.10% | 0.3064 | 0.3164 | 7000 | 292 | 87 | 37 |
| E5 | Sample 2 | 13.80% | 86.20% | | | | 296 | 90 | 49 |
| C6 | SCASN | 8.20% | 91.80% | 0.2952 | 0.3048 | 8000 | 286 | 87 | 37 |
| E6 | Sample 2 | 12.70% | 87.30% | | | | 289 | 90 | 48 |

As listed in Table 2, it was found that the light emitting device including the phosphor that contained a crystal phase having a composition represented by the formula [1] had excellent conversion efficiency and an excellent color rendering property in a wide color temperature range, as compared with a case where a red phosphor of the related art was used in the light emitting device.

Further, similarly, the characteristics of the image display device having the white LED as a backlight in the simulation were evaluated. The results of determining the conversion efficiency by using the phosphor of Example 2 (sample 2) or a SCASN phosphor (BR-102C, manufactured by Mitsubishi Chemical Corporation) having an emission peak wavelength of 628 nm as a red phosphor and a β-SiAlON phosphor (BG-601/K, manufactured by Mitsubishi Chemical Corporation) as a green phosphor and adjusting the chromaticity coordinate (x, y) after the light from the white LED was allowed to pass through a color filter used in a typical image display device (display or the like) to (0.3101, 0.3162) and the results of calculating what percentage of the color gamut that was displayed by the LED device covered the color gamut of NTSC (hereinafter, also referred to as the coverage rate) are listed in Table 3.

[Table 3]

| No. | Red phosphor | Relative value of mass of phosphor | | Chromaticity coordinate value | | LER (Lm/ Wopt) | NTSC color gamut coverage rate (%) |
|---|---|---|---|---|---|---|---|
| | | Red color | Green color | x | y | | |
| C7 | SCASN | 13.40% | 86.60% | 0.3101 | 0.3162 | 288 | 75% |
| E7 | Sample 2 | 20.70% | 79.30% | | | 298 | 76% |

As listed in Table 3, it was found that the light emitting device, the image display device, and the like, including the phosphor that contained a crystal phase having a composition represented by the formula [1] in the examples had excellent conversion efficiency and an excellent color gamut coverage rate as compared with a case where a red phosphor of the related art was used in the light emitting device, the image display device, and the like.

As described above, the phosphor containing a crystal phase having a composition represented by the formula [1] has a preferable wavelength as a red color and an excellent full width half maximum, and a light emitting device, a lighting device, an image display device, and an indicator lamp for a vehicle with an excellent color rendering property and other excellent characteristics can be provided by using a light emitting device including such a phosphor.

Although the present invention has been described in detail with reference to particular embodiments, it will be apparent to those skilled in the art that various modifications may be made therein without departing from the spirit and scope of the present invention.

The present application is based on Japanese Patent Application No. 2021-166903 filed October 11, 2021, and Japanese Patent Application No. 2021-166904 filed October 11, 2021, which are incorporated herein by reference in their entirety.

**Claims**

1. A light emitting device comprising:

    a phosphor that contains a crystal phase having a composition represented by the following formula [1],

$$Re_x(Sr_{1-y}MA_y)_aMB_bMC_cN_dO_eX_f \qquad [1]$$

    (In the formula [1],
    MA includes one or more elements selected from the group consisting of Ca, Ba, Na, K, Y, Gd, and La,
    MB includes one or more elements selected from the group consisting of Li, Mg, and Zn,
    MC includes one or more elements selected from the group consisting of Al, Si, Ga, In, and Sc,
    X includes one or more elements selected from the group consisting of F, Cl, Br, and I,
    Re includes one or more elements selected from the group consisting of Eu, Ce, Pr, Tb, and Dy, and
    a, b, c, d, e, f, x, and y respectively satisfy the following expressions.

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

2. The light emitting device according to claim 1,
   wherein in a powder X-ray diffraction spectrum of the phosphor, $0 < I_x/I_y < 0.2$ is satisfied when a peak intensity of (110) appearing in a region of $2\Theta = 10$ to $12$ degrees is defined as $I_x$, and a peak intensity of (121) appearing in a region of $2\Theta = 37$ to $39$ degrees is defined as $I_y$, and $I_z/I_y < 0.25$ is satisfied when a peak intensity of (111) derived from a SrO phase of an impurity phase appearing in a region of $2\Theta = 30$ degrees is defined as $I_z$.

3. The light emitting device according to claim 1 or 2,
   wherein in the formula [1], $0.0 \leq y \leq 0.05$ is satisfied.

4. The light emitting device according to any one of claims 1 to 3,
   wherein in the formula [1], MA is Ca.

**5.** The light emitting device according to any one of claims 1 to 4,
wherein in the formula [1], 80% by mole or greater of MB is formed of Li.

**6.** The light emitting device according to any one of claims 1 to 5,
wherein in the formula [1], 80% by mole or greater of MC is formed of Al.

**7.** The light emitting device according to any one of claims 1 to 6,
wherein in the formula [1], 80% by mole or greater of Re is formed of Eu.

**8.** The light emitting device according to any one of claims 1 to 7,
wherein the light emitting device has an emission peak wavelength in a wavelength range of 620 nm or greater and 645 nm or less in an emission spectrum.

**9.** The light emitting device according to any one of claims 1 to 8,
wherein a full width half maximum (FWHM) in an emission spectrum is 70 nm or less.

**10.** The light emitting device according to any one of claims 1 to 9, further comprising:
a yellow phosphor and/or a green phosphor.

**11.** The light emitting device according to claim 10,
wherein the yellow phosphor and/or the green phosphor includes any one or more of a garnet-based phosphor, a silicate-based phosphor, a nitride phosphor, and an oxynitride phosphor.

**12.** The light emitting device according to any one of claims 1 to 11, comprising:

a first phosphor; and
a second phosphor that emits visible light by irradiation with light from the first phosphor,
wherein the light emitting device includes a phosphor containing a crystal phase having a composition represented by the formula [1] as the second phosphor.

**13.** A lighting device comprising:
the light emitting device according to claim 12 as a light source.

**14.** An image display device comprising:
the light emitting device according to claim 12 as a light source.

**15.** An indicator lamp for a vehicle, comprising:
the light emitting device according to claim 12 as a light source.

**16.** A phosphor comprising:

a crystal phase having a composition represented by the following formula [1],

$$Re_x(Sr_{1-y}MA_y)_aMB_bMC_cN_dO_eX_f \qquad [1]$$

(In the formula [1],
MA includes one or more elements selected from the group consisting of Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, f, x, and y respectively satisfy the following expressions.

$$0.8 \leq a \leq 1.2$$

$$1.4 \leq b \leq 2.6$$

$$1.4 \leq c \leq 2.6$$

$$1.1 \leq d \leq 2.9$$

$$1.1 \leq e \leq 2.9$$

$$0.0 \leq f \leq 0.1$$

$$0.0 < x \leq 0.2$$

$$0.0 < y \leq 0.7)$$

17. The phosphor according to claim 16,
    wherein in a powder X-ray diffraction spectrum of the phosphor, 0 < Ix/Iy < 0.2 is satisfied when a peak intensity of (110) appearing in a region of 2Θ = 10 to 12 degrees is defined as Ix, and a peak intensity of (121) appearing in a region of 2Θ = 37 to 39 degrees is defined as Iy, and Iz/Iy < 0.25 is satisfied when a peak intensity of (111) derived from a SrO phase of an impurity phase appearing in a region of 2Θ = 30 degrees is defined as Iz.

18. The phosphor according to claim 16 or 17,
    wherein in the formula [1], $0.0 \leq y \leq 0.05$ is satisfied.

19. The phosphor according to any one of claims 16 to 18, wherein in the formula [1], MA is Ca.

20. The phosphor according to any one of claims 16 to 19, wherein in the formula [1], 80% by mole or greater of MB is formed of Li.

21. The phosphor according to any one of claims 16 to 20, wherein in the formula [1], 80% by mole or greater of MC is formed of Al.

22. The phosphor according to any one of claims 16 to 21, wherein in the formula [1], 80% by mole or greater of Re is formed of Eu.

23. The phosphor according to any one of claims 16 to 22, wherein the phosphor has an emission peak wavelength in a wavelength range of 620 nm or greater and 645 nm or less in an emission spectrum.

24. The phosphor according to any one of claims 16 to 23, wherein a full width half maximum (FWHM) in an emission spectrum is 70 nm or less.

Fig. 1

Fig. 2

# Fig. 3

## INTERNATIONAL SEARCH REPORT

| International application No. |
|---|
| **PCT/JP2022/037589** |

### A. CLASSIFICATION OF SUBJECT MATTER

*H01L 33/50*(2010.01)i; *C09K 11/08*(2006.01)i; *C09K 11/59*(2006.01)i; *C09K 11/61*(2006.01)i; *C09K 11/62*(2006.01)i; *C09K 11/64*(2006.01)i; *C09K 11/78*(2006.01)i; *C09K 11/79*(2006.01)i; *C09K 11/80*(2006.01)i; *C09K 11/86*(2006.01)i; *F21S 2/00*(2016.01)i; *F21S 43/14*(2018.01)i; *F21V 9/30*(2018.01)i; *F21V 9/38*(2018.01)i; *G02B 5/20*(2006.01)i; *F21Y 115/10*(2016.01)n

FI: H01L33/50; G02B5/20; C09K11/78; C09K11/79; C09K11/80; C09K11/86; C09K11/62; C09K11/59; C09K11/08 J; F21V9/38; F21V9/30; F21S43/14; F21S2/00 481; C09K11/64; C09K11/61; F21Y115:10

According to International Patent Classification (IPC) or to both national classification and IPC

### B. FIELDS SEARCHED

Minimum documentation searched (classification system followed by classification symbols)

H01L33/00-33/64; C09K11/00-11/89; F21S2/00; F21S43/14; F21V9/30; F21V9/38; G02B5/20; F21Y115/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/262200 A1 (DENKA COMPANY LTD) 30 December 2020 (2020-12-30) paragraphs [0019]-[0105], [0138]-[0141], fig. 1-4 | 1, 3-8, 10-16, 18-23 |
| Y | | 2, 9, 17, 24 |
| Y | WO 2016/076380 A1 (MITSUBISHI CHEM CORP) 19 May 2016 (2016-05-19) paragraphs [0041]-[0045] | 2, 9, 17, 24 |
| Y | WO 2021/015004 A1 (DENKA COMPANY LTD) 28 January 2021 (2021-01-28) paragraphs [0053], [0062], [0071]-[0083] | 9, 24 |
| A | JP 2006-503431 A (KONINKLIJKE PHILIPS ELECTRONICS N.V) 26 January 2006 (2006-01-26) entire text, all drawings | 1-24 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 December 2022** | **27 December 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2022/037589** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2020-535651 A (LUMILEDS LLC) 03 December 2020 (2020-12-03)<br>entire text, all drawings | 1-24 |
| A | US 2021/0045207 A1 (ECOSENSE LIGHTING INC.) 11 February 2021 (2021-02-11)<br>entire text, all drawings | 1-24 |

Form PCT/ISA/210 (second sheet) (January 2015)

**INTERNATIONAL SEARCH REPORT**
Information on patent family members

International application No.

**PCT/JP2022/037589**

| Patent document cited in search report | | | Publication date (day/month/year) | Patent family member(s) | | | Publication date (day/month/year) |
|---|---|---|---|---|---|---|---|
| WO | 2020/262200 | A1 | 30 December 2020 | US | 2022/0367760 | A1 | |
| | | | | paragraphs [0036]-[0154], [0197]-[0202], fig. 1-4 | | | |
| | | | | CN | 114008175 | A | |
| | | | | KR | 10-2022-0024112 | A | |
| WO | 2016/076380 | A1 | 19 May 2016 | TW | 201625774 | A | |
| WO | 2021/015004 | A1 | 28 January 2021 | (Family: none) | | | |
| JP | 2006-503431 | A | 26 January 2006 | US | 2006/0011922 | A1 | |
| | | | | WO | 2004/036962 | A1 | |
| | | | | EP | 1554914 | A1 | |
| JP | 2020-535651 | A | 03 December 2020 | US | 2019/0093832 | A1 | |
| | | | | US | 2021/0018152 | A1 | |
| | | | | US | 2022/0146058 | A1 | |
| | | | | WO | 2019/067384 | A1 | |
| | | | | KR | 10-2020-0052964 | A | |
| | | | | CN | 111357122 | A | |
| | | | | KR | 10-2021-0151995 | A | |
| US | 2021/0045207 | A1 | 11 February 2021 | US | 2018/0338362 | A1 | |
| | | | | US | 2022/0204839 | A1 | |
| | | | | US | 2017/0223786 | A1 | |
| | | | | US | 2019/0029092 | A1 | |
| | | | | US | 2019/0098720 | A1 | |
| | | | | US | 2020/0120776 | A1 | |
| | | | | US | 2020/0163185 | A1 | |
| | | | | US | 2021/0068221 | A1 | |
| | | | | US | 2021/0136887 | A1 | |
| | | | | US | 9609715 | B1 | |
| | | | | WO | 2017/131699 | A1 | |
| | | | | CN | 109315037 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6335884 B
- JP 2007291352 A
- JP 2021166903 A
- JP 2021166904 A

**Non-patent literature cited in the description**

- A SPACE-GROUP SYMMETRY. International Tables for Crystallography